# EUROPEAN PATENT APPLICATION

(11) **EP 4 336 487 A1**
(43) Date of publication of application: **13.03.2024**
(21) Application number: 22819107.8
(22) Date of filing: 18.02.2022
(51) Int. Cl.: G09G 3/3266

(54) **DISPLAY PANEL AND DISPLAY DEVICE**

(30) Priority: 09.06.2021 CN 202110644643
(71) Applicant: Honor Device Co., Ltd., Shenzhen, Guangdong 518040 (CN)
(72) Inventor: TIAN, Zheng, Shenzhen, Guangdong 518040 (CN)
(74) Representative: Gill Jennings & Every LLP
(86) International application number: PCT/CN2022/076958
(87) International publication number: WO 2022/257500

(57) **Abstract**

Embodiments of this application provide a display panel and a display device, which are applied to the field of terminal technologies. The display panel includes: a display region and a peripheral region that at least partially surrounds the display region. The display region includes a first edge to a fourth edge that are disposed opposite to each other. A corner between the first edge and the fourth edge is curved. The display region includes a plurality of pixel units. Peripheral regions corresponding to the first edge, a second edge, and a third edge each include a gate driver on array GOA circuit and a GOA signal line. The GOA circuit is configured to drive the pixel unit, and the GOA signal line is used to connect the GOA circuit and the pixel unit. The peripheral regions corresponding to the first edge, the second edge, and the third edge include all GOA circuits. In this way, the GOA circuit does not occupy space in a peripheral region corresponding to a corner, a width of the peripheral region corresponding to a corner is reduced, and a border frame of the corner is narrowed. This beautifies visual effect and reduces wrinkles in production.

## Description

This application claims priority to Chinese Patent Application No. 202110644643.X, filed with the China National Intellectual Property Administration on June 9, 2021, and entitled "DISPLAY PANEL AND DISPLAY DEVICE", which is incorporated herein by reference in its entirety.

### TECHNICAL FIELD

This application relates to the field of terminal technologies, and in particular to a display panel and a display device.

### BACKGROUND

With the rapid development of terminals such as smartphones, an increasing number of flexible displays are used in the terminals. The flexible display may be made into a foldable screen, a curved screen, a stretched screen, and a screen in another form due to variable and bendable characteristics. Currently, there is a "waterfall screen" on the market is characterized with that a left edge and a right edge are bent.

When four edges of the flexible display are bent, at a rounded (R) corner, that is, a junction of two adjacent curved surfaces, some film layers are accumulated due to uneven stress. As a result, wrinkles occur. To reduce the accumulation of the film layer, avoid the wrinkles, and beautify visual effect, a border frame at an R corner is to be narrowed.

How to narrow the border frame at the R corner is a key technical problem to be resolved. In a current circuit architecture, a gate driver on array (gate driver on array, GOA) circuit and a signal line of the GOA circuit are disposed at the R comer. The GOA circuit and the signal line of the GOA circuit occupy space in an R corner region. As a result, the border frame at the R corner is large and cannot be narrowed.

### SUMMARY

Embodiments of this application provide a display panel and a display device. GOA circuits are disposed in an upper border frame and/or a left border frame and a right border frame. Therefore, space in an R corner is not occupied. This may narrow a border frame at the R corner, beautify visual effect, and reduces wrinkles in production.

According to a first aspect, an embodiment of this application provides a display panel, applied to a terminal device having a display function. The display panel includes: a display region and a peripheral region that at least partially surrounds the display region. The display region includes a first edge, a second edge, a third edge, and a fourth edge. The first edge is disposed opposite to the second edge, the third edge is disposed opposite to the fourth edge, and a corner between the first edge and the fourth edge is curved. The display region includes a plurality of pixel units. Peripheral regions corresponding to the first edge, the second edge, and the third edge each include a gate driver on array GOA circuit and a GOA signal line. The GOA circuit is configured to drive the pixel unit, and the GOA signal line is used to connect the GOA circuit and the pixel unit. The peripheral regions corresponding to the first edge, the second edge, and the third edge include all GOA circuits.

In this way, the GOA circuits are disposed in the peripheral regions corresponding to the first edge, the second edge, and the third edge, to enable the GOA circuits not to occupy space in a corner region. This narrows a border frame at the corner, beautifies visual effect, and avoids wrinkles.

Optionally, a peripheral region corresponding to the corner includes a panel crack detection PCD lead and a water-and-oxygen dam (Dam) region, and a distance between the PCD lead and the corner is less than a distance between the Dam region and the corner, to enable the PCD lead not to pass through the Dam region.

In this way, the PCD lead does not pass through the Dam region, to improve effect of isolating water and oxygen in the Dam region, and avoid effect loss of an organic material in the display region.

Optionally, the peripheral region corresponding to the corner further includes an isolation column, and the isolation column is disposed on both sides of the Dam region.

In this way, the isolation column further isolates water and oxygen, to avoid the effect loss of the organic material in the display region.

Optionally, a width of a peripheral region at the corner is smaller than a width of a peripheral region at the first edge.

Optionally, the peripheral region includes a signal providing region, the signal providing region is adjacent to the fourth edge, and a length of the signal providing region is smaller than or equal to a length of the fourth edge. The display region further includes K data connection lines disposed between the pixel units, and K is a natural number. The pixel units include M columns * N rows of light-emitting devices, M columns * N rows of bottom drive circuits, and M * N anode leads. The anode leads are used to connect the light-emitting devices to the bottom drive circuits, the bottom drive circuits are disposed at lower layers of the light-emitting devices, and both M and N are natural numbers. An interval between adjacent light-emitting devices in the pixel unit is larger than a dimension of the bottom drive circuits corresponding to the adjacent light-emitting devices in the pixel units, to enable a gap to exist between the pixel units. The K data connection lines are used to pass through gaps between the plurality of pixel units in the display region, and to connect pixel units in Q columns in the plurality of pixel units to the signal providing region. The pixel units in Q columns include pixel units corresponding to the corner, and Q is a natural number less than or equal to K.

In this way, a data connection line passes through the gaps between the plurality of pixel units in the display region without occupying space in a lower border frame is occupied. Therefore, the lower border frame is narrowed.

According to a second aspect, an embodiment of this application provides a display panel, applied to a terminal device having a display function. The display panel includes: a display region and a peripheral region that at least partially surrounds the display region. The display region includes a first edge, a second edge, a third edge, and a fourth edge. The first edge is disposed opposite to the second edge, the third edge is disposed opposite to the fourth edge, and a corner between the first edge and the fourth edge is curved. The display region includes a plurality of pixel units. Peripheral regions corresponding to the first edge and the second edge each include a gate driver on array GOA circuit and a GOA signal line. The GOA circuit is configured to drive the pixel unit, and the GOA signal line is used to connect the GOA circuit and the pixel unit. A longitudinal dimension of the GOA circuit is smaller than a longitudinal dimension of the pixel unit corresponding to a GOA circuit, to enable the peripheral regions corresponding to the first edge and the second edge to include all GOA circuits.

In this way, the GOA circuits are reduced and disposed in the peripheral regions corresponding to the first edge and the second edge, enabling the GOA circuits not to occupy space in a corner region. This narrows a border frame at the R corner, beautifies visual effect, and avoids wrinkles.

Optionally, a peripheral region corresponding to the corner includes a panel crack detection PCD lead and a water-and-oxygen dam (Dam) region, and a distance between the PCD lead and the corner is less than a distance between the Dam region and the corner, to enable the PCD lead not to pass through the Dam region.

In this way, the PCD lead does not pass through the Dam region, to improve effect of isolating water and oxygen in the Dam region, and avoid effect loss of an organic material in the display region.

Optionally, the peripheral region corresponding to the corner further includes an isolation column, and the isolation column is disposed on both sides of the Dam region.

In this way, the isolation column further isolates water and oxygen, to avoid the effect loss of the organic material in the display region.

Optionally, a width of a peripheral region at the corner is smaller than a width of a peripheral region at the first edge.

Optionally, the peripheral region includes a signal providing region, the signal providing region is adjacent to the fourth edge, and a length of the signal providing region is smaller than or equal to a length of the fourth edge. The display region further includes K data connection lines disposed between the pixel units, and K is a natural number. The pixel units include M columns * N rows of light-emitting devices, M columns * N rows of bottom drive circuits, and M * N anode leads. The anode leads are used to connect the light-emitting devices to the bottom drive circuits, the bottom drive circuits are disposed at lower layers of the light-emitting devices, and both M and N are natural numbers. An interval between adjacent light-emitting devices in the pixel unit is larger than a dimension of the bottom drive circuits corresponding to the adjacent light-emitting devices in the pixel units, to enable a gap to exist between the pixel units. The K data connection lines are used to pass through gaps between the plurality of pixel units in the display region, and to connect pixel units in Q columns in the plurality of pixel units to the signal providing region. The pixel units in Q columns include pixel units corresponding to the corner, and Q is a natural number less than or equal to K.

In this way, a data connection line passes through the gaps between the plurality of pixel units in the display region without occupying space in a lower border frame is occupied. Therefore, the lower border frame is narrowed.

According to a third aspect, an embodiment of this application provides a display panel, applied to a terminal device having a display function. The display panel includes: a display region and a peripheral region that at least partially surrounds the display region. The display region includes a first edge, a second edge, a third edge, and a fourth edge. The first edge is disposed opposite to the second edge, the third edge is disposed opposite to the fourth edge, and a corner between the first edge and the fourth edge is curved. The display region includes a plurality of pixel units. Peripheral regions corresponding to the first edge, the second edge, and the third edge each include a gate driver on array GOA circuit and a GOA signal line. The GOA circuit is configured to drive the pixel unit, and the GOA signal line is used to connect the GOA circuit and the pixel unit. A GOA circuit connected to a first pixel unit is disposed in a peripheral region corresponding to a third edge. A GOA circuit connected to a second pixel unit is disposed in a peripheral region that are corresponding to a first edge and a second edge. The first pixel unit is a pixel unit from which a distance to the third edge in a column direction is less than or equal to a first threshold value, and the second pixel unit is a pixel unit from which a distance to the third edge in the column direction is less than or equal to the first threshold value.

In this way, the GOA circuits are disposed in the peripheral regions corresponding to the first edge, the second edge, and the third edge, to enable the GOA circuits not to occupy space in a corner region. This narrows a border frame at the R corner, beautifies visual effect, and avoids wrinkles.

Optionally, a peripheral region corresponding to the corner includes a panel crack detection PCD lead and a water-and-oxygen dam (Dam) region, and a distance between the PCD lead and the corner is less than a distance between the Dam region and the corner, to enable the PCD lead not to pass through the Dam region.

In this way, the PCD lead does not pass through the Dam region, to improve effect of isolating water and oxygen in the Dam region, and avoid effect loss of an organic material in the display region.

Optionally, the peripheral region corresponding to the corner further includes an isolation column, and the isolation column is disposed on both sides of the Dam region.

In this way, the isolation column further isolates water and oxygen, to avoid the effect loss of the organic material in the display region.

Optionally, a width of a peripheral region at the corner is smaller than a width of a peripheral region at the first edge.

Optionally, the peripheral region includes a signal providing region, the signal providing region is adjacent to the fourth edge, and a length of the signal providing region is smaller than or equal to a length of the fourth edge. The display region further includes K data connection lines disposed between the pixel units, and K is a natural number. The pixel units include M columns * N rows of light-emitting devices, M columns * N rows of bottom drive circuits, and M * N anode leads. The anode leads are used to connect the light-emitting devices to the bottom drive circuits, the bottom drive circuits are disposed at lower layers of the light-emitting devices, and both M and N are natural numbers. An interval between adjacent light-emitting devices in the pixel unit is larger than a dimension of the bottom drive circuits corresponding to the adjacent light-emitting devices in the pixel units, to enable a gap to exist between the pixel units. The K data connection lines are used to pass through gaps between the plurality of pixel units in the display region, and to connect pixel units in Q columns in the plurality of pixel units to the signal providing region. The pixel units in Q columns include pixel units corresponding to the corner, and Q is a natural number less than or equal to K.

In this way, a data connection line passes through the gaps between the plurality of pixel units in the display region without occupying space in a lower border frame is occupied. Therefore, the lower border frame is narrowed.

According to a fourth aspect, an embodiment of this application further provides a display. The display includes any one display panel according to the first aspect, the second aspect, and the third aspect, and the display panel is configured to display an image.

For beneficial effects brought by the display provided in the fourth aspect and the possible designs of the fourth aspect, refer to beneficial effects brought by the display panel provided in the first aspect and the possible designs of the first aspect. Details are not described herein again.

According to a fifth aspect, an embodiment of this application provides a display device, including the display according to the third aspect. The display is configured to display an image.

For beneficial effects brought by the display device provided in the fifth aspect and the possible designs of the fifth aspect, refer to beneficial effects brought by the display panel provided in the first aspect and the possible designs of the first aspect. Details are not described herein again.

### BRIEF DESCRIPTION OF DRAWINGS

FIG. 1 is a schematic diagram of a three-dimensional structure of a flexible display according to a possible implementation;
FIG. 2 is a schematic plane view of a display panel according to a possible implementation;
FIG. 3 is a schematic diagram of a structure of a display panel according to a possible implementation;
FIG. 4 is a schematic diagram of a structure of an R comer of a display panel according to a possible implementation;
FIG. 5 is a schematic diagram of structures of a part of an upper border frame region and an R comer region of a display panel according to a possible implementation;
FIG. 6 is a schematic diagram of a structure of a display panel according to an embodiment of this application;
FIG. 7 is a comparison diagram of a display panel according to an embodiment of this application;
FIG. 8 is a schematic diagram of a structure of an R comer of a display panel according to an embodiment of this application;
FIG. 9 is a schematic diagram of a structure of an R comer of a display panel according to an embodiment of this application;
FIG. 10 is a schematic diagram of a structure of a display panel according to an embodiment of this application;
FIG. 11 is a schematic diagram of a structure of a cross section of a border frame at an R corner according to an embodiment of this application;
FIG. 12 is a schematic diagram of a structure of a cross section of a border frame at an R corner according to an embodiment of this application;
FIG. 13 is a schematic diagram of a structure of a pixel unit according to an embodiment of this application;
FIG. 14 is a schematic diagram of a structure of a specific display circuit according to an embodiment of this application;
FIG. 15 is a schematic diagram of a structure of a specific display circuit according to an embodiment of this application;
FIG. 16 is a schematic diagram of a structure of a display according to an embodiment of this application; and
FIG. 17 is a schematic diagram of a structure of a display device according to an embodiment of this application.

### DESCRIPTION OF EMBODIMENTS

To clearly describe the technical solutions in embodiments of this application, terms such as "first" and "second" are used in embodiments of this application to distinguish between same items or similar items that provide basically same functions or purposes. For example, a first device and a second device are merely used to distinguish between different devices, and are not intended to limit a sequence thereof. A person skilled in the art may understand that the words such as "first" and "second" do not limit a quantity or an execution sequence, and the words such as "first" and "second" do not indicate a definite difference.

It should be noted that, in embodiments of this application, a word such as "example" or "for example" is used to represent giving an example, an illustration, or a description. Any embodiment or design solution described as an "example" or "for example" in embodiments of this application should not be explained as being more preferred or having more advantages than other embodiments or design solutions. To be precise, the word such as "example" or "for example" is intended to present a related concept in a specific manner.

It should be noted that, in embodiments of this application, "include" and/or "contain" specify/specifies existence of stated features or elements, but do/does not exclude existence or addition of one or more other features or elements. On the contrary, "consist of" specifies existence of stated features or elements and excludes existence of other features or elements.

Further, when a layer, a region, or an element is referred to as "being" located "on" another layer, another region, or another element, it indicates that the layer, the region, or the element is directly or indirectly located on the another layer, the another region, or the another element. For example, there may be an intermediate layer, an intermediate region, or an intermediate element.

For ease of description, a dimension of an element in the accompanying drawings may be exaggerated or reduced. Therefore, although a relative dimension and angle of the element shown in the accompanying drawings may indicate at least one example embodiment of the present disclosure, there may be other example embodiments of the present disclosure having a relative dimension and angle different from the shown relative dimension and angle.

When a wiring is referred to as "extending in a first direction or a second direction", it indicates that the wiring may extend not only in a linear shape, but also in a zigzag or curved shape in the first direction or the second direction. In addition, when it is said that a wiring or an element extends in a specific direction, it indicates that the wiring or the element extends mainly in the specific direction. For example, the wiring or the element extends farther in the specific direction than in any other direction.

In embodiments of this application, "in a plan view" means a diagram of a target part viewed from above, and "in a cross-sectional view" means a vertical cross-sectional view of the target part viewed from a side. Unless otherwise defined, the term "overlap" includes overlapping "in a plan view" and "in a cross-sectional view". Unless otherwise defined, the signals described in this specification are generic terms for voltage or current.

With the rapid development of terminals such as smartphones, an increasing number of flexible displays are used in the terminals. The flexible display has variable and bendable characteristics, and has a characteristic of low power consumption because an organic light-emitting diode (organic light-emitting diode, OLED) technology is used for the flexible display.

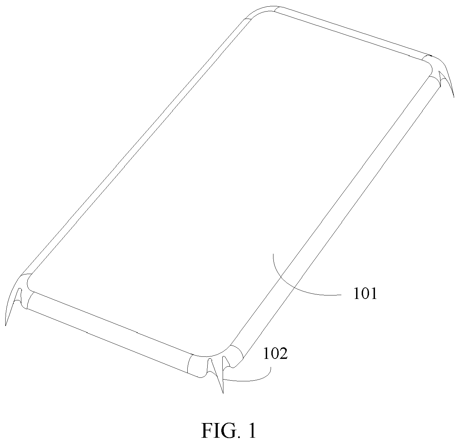

When four edges of the flexible display are bent, at four R corners, some film layers are accumulated due to uneven stress. As a result, wrinkles occur. For example, FIG. 1 is a schematic diagram of a three-dimensional structure of a flexible display according to a possible implementation. When a quad-curved display, that is, a display with bent parts on all four sides, is manufactured, at a junction of adjacent sides of a flexible display 101, wrinkles 102 occur due to accumulation of film layers of the display. The wrinkles 102 not only affect attaching effect of the flexible display 101 with other parts of a mobile phone such as a glass backplane, but also cause adverse effect on display performance of the flexible display 101.

To avoid the wrinkles and beautify visual effect, a border frame at an R corner of the display is to be narrowed. The display panel is an important component of the display. When the border frame at the R corner in the display panel is narrowed, a corresponding border frame at the R corner in the display is narrowed.

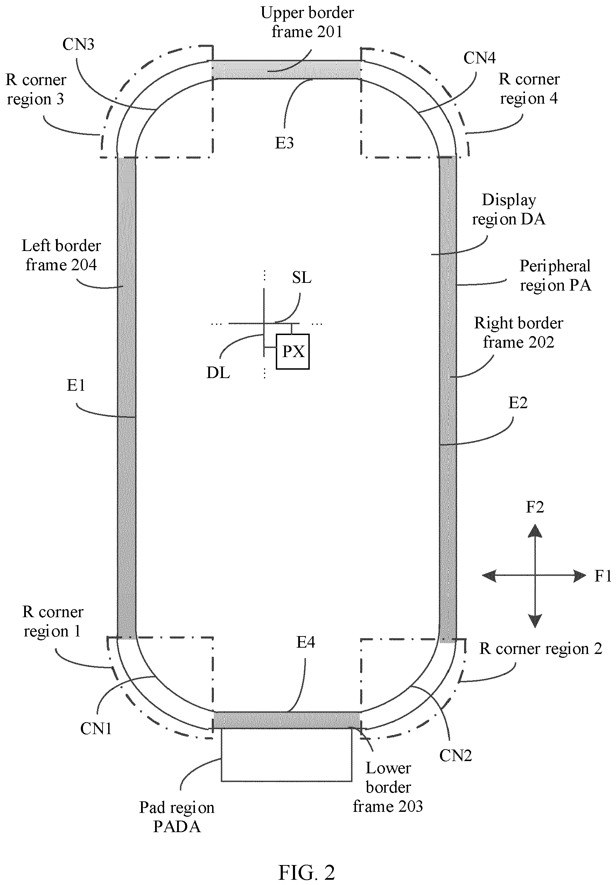

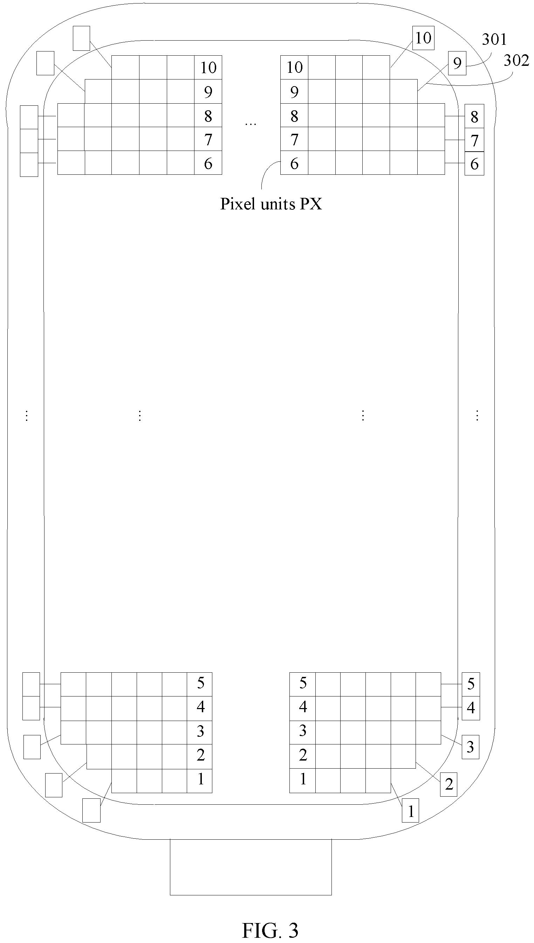

To facilitate understanding of a display panel provided in embodiments of this application, the following describes a structure of the display panel in possible implementations with reference to FIG. 2 and FIG. 3.

FIG. 2 is a schematic plane view of a display panel according to a possible implementation. The display panel includes a display region DA and a peripheral region PA. The peripheral region PA is located outside the display region DA, and at least partially surrounds the display region DA.

The display region DA is used to display an image. Edges of the display region DA may form a right angle. As shown in FIG. 2, a first corner CN1 at an edge of the display region DA may have a circular shape. Specifically, the display region DA may include a first edge E1 and a second edge E2 that are disposed opposite to each other, and a third edge E3 and a fourth edge E4 that are located between the first edge E1 and the second edge E2 and that are disposed opposite to each other. The first edge E1 and the fourth edge E4 may be connected by using the first corner CN1 having a circular shape, and the second edge E2 and the fourth edge E4 may be connected by using a second corner CN2 having a circular shape. The first edge E1 and the third edge E3 may be connected by using a third corner CN3 having a circular shape, and the second edge E2 and the third edge E3 may be connected by using a fourth corner CN4 having a circular shape.

It may be understood that a part of a display region DA and a part of a border frame region PA that are corresponding to the first corner CN1 in the display panel shown in FIG. 2 may be referred to as an R comer region 1. A part of a display region DA and a part of a border frame region PA that are corresponding to the second corner CN2 may be referred to as an R corner region 2. A part of a display region DA and a part of a border frame region PA that are corresponding to the third corner CN3 may be referred to as an R corner region 3. A part of a display region DA and a part of a border frame region PA that are corresponding to the fourth corner CN4 may be referred to as an R corner region 4.

The display region DA includes a plurality of pixel units PX and wirings that can apply an electrical signal to the plurality of pixel units PX.

Each of the plurality of pixel units PX may include a light-emitting device and a circuit part configured to drive the light-emitting device. For example, the light-emitting device may be an organic light-emitting diode, and the circuit part may include a plurality of transistors, capacitors, and the like.

The wirings that can apply an electrical signal to the plurality of pixel units PX may include a plurality of scanning lines SL, a plurality of data lines DL, and the like. Each of the plurality of scanning lines SL may extend in a first direction F 1, and each of the plurality of data lines DL may extend in a second direction F2. The plurality of scanning lines SL, for example, may be disposed in a plurality of rows to transmit a scanning signal to the pixel PX, and the plurality of data lines DL may be disposed in a plurality of columns to transmit a data signal to the pixel unit PX. Each of the plurality of pixel units PX may be connected to a corresponding scanning line SL in the plurality of scanning lines SL and a corresponding data line DL in the plurality of data lines DL.

The peripheral region PA may at least partially surround the display region DA. A peripheral region PAin which the pixel unit PX is not disposed may be simply divided into a border frame region adjacent to the display region DA and a pad region PADA.

For ease of description, in this embodiment of this application, the border frame region is divided into an upper border frame region 201, a right border frame region 202, a lower border frame region 203, a left border frame region 204, a border frame region corresponding to the first corner CN1, a border frame region corresponding to the second corner CN2, a border frame region corresponding to the third corner CN3, and a border frame region corresponding to the fourth corner CN4.

It may be understood that the upper border frame region 201 is a peripheral region corresponding to the third edge; the right border frame region 202 is a peripheral region corresponding to the second edge; the lower border frame region 203 is a peripheral region corresponding to the fourth edge; the left border frame region 204 is a peripheral region corresponding to the first edge; the border frame region corresponding to the first corner CN1 may also be referred to as a peripheral region corresponding to the first corner CN1; the border frame region corresponding to the second corner CN2 may also be referred to as a peripheral region corresponding to the second corner CN2; the border frame region corresponding to the third corner CN3 may also be referred to as a peripheral region corresponding to the third corner CN3; and the border frame region corresponding to the fourth corner CN4 may also be referred to as a peripheral region corresponding to the fourth corner CN4.

It should be noted that the upper border frame region 201, the right border frame region 202, and the left border frame region 204 each include a signal line required for working of a pixel unit, a VSS signal providing region, a protection and detection region, and a water-and-oxygen dam (Dam) region.

The signal line required for working of a pixel unit includes a direct current power line (vinit line) and the like.

The VSS signal providing region is used to output a cathode signal for the display region DA. Specifically, a VSS circuit of the VSS signal providing region is connected to a cathode of the pixel unit PX, to provide the cathode signal to the pixel unit PX.

The protection and detection region is used to protect and detect the panel. The protection and detection region includes, but is not limited to, a panel crack detection (panel crack detection, PCD) circuit and an isolation column. The isolation column is used to isolate water, oxygen, and the like in the air, to avoid water absorption by an organic material in the display panel.

The Dam region includes a Dam packaging unit. The DamAM packaging unit is configured to isolate water, oxygen, and the like in the air, to avoid water absorption by the organic material in the display panel.

The right border frame region 202 and the left border frame region 204 each further include a GOA region. The GOA region is used to drive the pixel unit PX to display an image. The GOA region includes a GOA circuit. The GOA circuit may include a scan driver SDV, an emit driver EDV, and/or the like. The scan driver SDV is configured to supply one or more electrical signals, such as the scanning signal, to the pixel unit PX along a signal line such as the scanning line SL. The emit driver EDV is configured to supply one or more electrical signals, such as an emitting control signal, to the pixel unit PX along a signal line such as an emitting control line.

The lower border frame region 203 includes a power supply lead and a signal line from an integrated circuit IC. The power supply lead is used to supply power to the display region DA. The signal line from an integrated circuit IC is used to transmit the data signal to the pixel unit PX, control the pixel unit PX to emit light, and further control display of the display region DA.

The border frame region corresponding to the first corner CN1, the border frame region corresponding to the second corner CN2, the border frame region corresponding to the third corner CN3, and the border frame region corresponding to the fourth corner CN4 each include the GOA circuit, the VSS signal providing region, the protection and detection region, and the Dam region.

The pad region PADA is a region in which various electronic devices, printed circuit boards, or the like are electrically attached. A plurality of pads in the pad region PADA may be electrically connected to a data driver. For example, the pad region PADA includes a signal providing region. The signal providing region is used to transmit the data signal to the pixel unit PX.

It may be understood that the display panel shown in FIG. 2 may be used in a flexible display. When four edges of the flexible display are bent, wrinkles occur at four R corners. To avoid the wrinkles and beautify visual effect, a border frame at the R comer needs to be narrowed.

However, the GOA circuit and a signal line of the GOA circuit are disposed in the R corner region.

For example, FIG. 3 is a schematic plane view of an arrangement of GOA circuits corresponding to FIG. 2. As shown in FIG. 3, GOA circuits 301 are separately disposed in the left border frame region, the right border frame region, the border frame region corresponding to the first corner CN1, the border frame region corresponding to the second corner CN2, the border frame region corresponding to the third corner CN3, and the border frame region corresponding to the fourth corner CN4.

It should be noted that, pixel units PX in the display panel shown in FIG. 3 are driven on both sides, and pixel units PX in each row are correspondingly connected to the GOA driver circuits 301 on both sides through GOA signal lines 302. The GOA circuits on both sides of the pixel units PX are arranged in a same or similar manner. GOA circuits 301 on one side of the pixel units PX are described in this embodiment of this application, and details of GOA circuits 301 on the other side of the pixel units PX are not described.

The following describes an arrangement of the GOA circuits 301 on a right side of the pixel units PX. FIG. 3 shows an example of ten rows of pixel units PX and corresponding GOA circuits 301. As shown in FIG. 3, pixel units PX in a first row to a tenth row are sequentially disposed from bottom to up in a display region DA, and a first GOA circuit 201 to a tenth GOA circuit 201 are sequentially disposed from bottom to up in a corresponding peripheral region PA.

Some pixel units PX in the first row to the third row are located in the R corner region 2, and correspondingly, the first GOA circuit 201 to the third GOA circuit 201 are located in the R corner region 2. The fourth GOA circuit 201 to the eighth GOA circuit 201 corresponding to pixel units PX in the fourth row to the eighth row are located in the right border frame region. Some pixel units PX in the ninth row and the tenth row are located in the R corner region 4, and correspondingly, the ninth GOA circuit 201 and the tenth GOA circuit 201 are located in the R corner region 4.

It should be noted that a number of rows of pixel units in the display panel may be another number, which is not limited in this embodiment of this application.

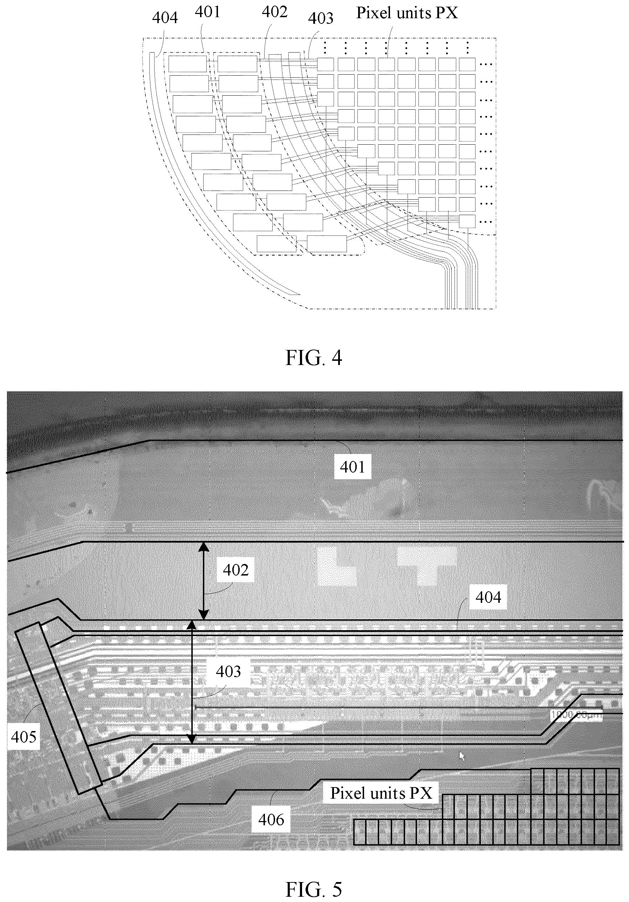

FIG. 4 is a schematic plane view of an enlarged structure of the R corner region shown in FIG. 3. As shown in FIG. 4, the R corner region 1 includes pixel units PX, GOA circuits 401, GOA signal lines 402, GOA output lines 403, and VSS traces 404. The GOA output line 403 is a lead (for example, a scanning line, an emitting control line, or the like) that is connected to a row of the pixel units PX. The GOA output line 403 is located in the display region. The GOA circuits 401 are connected to the pixel units PX through the GOA signal line 402 and the GOA output line 403, to control the pixel units PX to display an image. The VSS trace 404 is used to transmit the cathode signal. The VSS trace 404 is located on an outer side of the GOA circuits 401.

In the display panel shown in FIG. 3 and FIG. 4, the GOA circuit and the signal line of the GOA circuit occupy space in the R comer region. As a result, the border frame in the R corner region is large and cannot be narrowed.

In view of this, in this embodiment of this application, because the GOA circuit is arranged in the upper border frame region, the left border frame region, and the right border frame region, the GOA circuit does not occupy the space in the R corner region, and a border frame in the R corner region can be narrowed.

It should be noted that there is unoccupied space in the upper border frame region of the display panel. For example, FIG. 5 is a schematic diagram of structures of a part of an upper border frame region and an R corner region of a display panel according to a possible implementation. As shown in FIG. 5, a border frame region includes a boundary 501, a cathode signal providing region 502, unoccupied space 503, a signal line 504 of a GOA circuit. A corner region includes a GOA circuit 505 and a GOA signal line 506. The signal line 504 of the GOA circuit is used to connect GOA circuits on both sides of the display panel. The upper border frame region in FIG. 5 includes the unoccupied space 503.

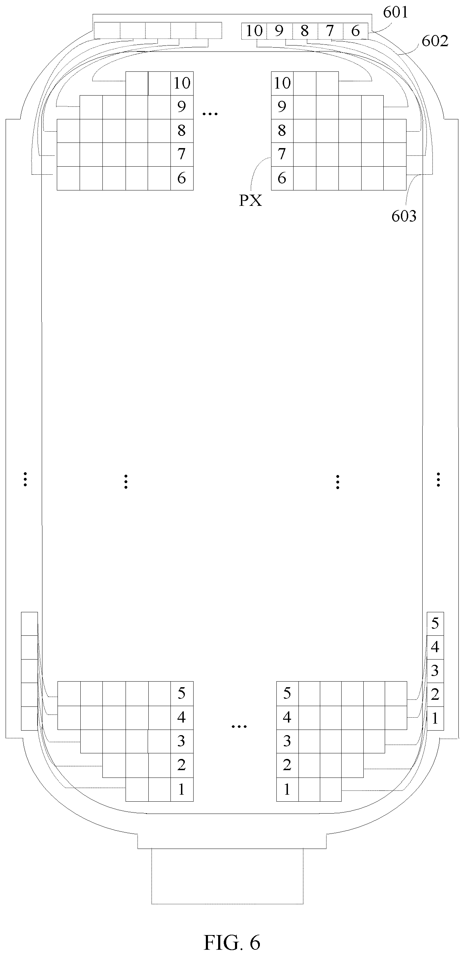

FIG. 6 is a schematic plane view of an arrangement of GOA circuits according to an embodiment of this application. As shown in FIG. 6, GOA circuits 601 are separately disposed in a left border frame region, a right border frame region, and an upper border frame region. The GOA circuits 601 are connected to pixel units PX through GOA signal lines 602 and GOA output lines 603. FIG. 6 shows an example of ten rows of pixel units PX and corresponding GOA circuits. As shown in FIG. 6, pixel units PX in a first row to a tenth row are sequentially disposed from bottom to up in a display region DA, and a first GOA circuit to a tenth GOA circuit are sequentially disposed from bottom to up in a corresponding peripheral region PA.

Specifically, some pixel units PX in the first row to the third row are located in an R corner region 2, and correspondingly, the first GOA circuit to the third GOA circuit are located in the right border frame region. The fourth GOA circuit to the eighth GOA circuit corresponding to pixel units PX in the fourth row to the eighth row sequentially move upward. When the GOA circuit moves upward to the R corner region, the GOA circuit moves to the upper border frame region. The fourth GOA circuit and the fifth GOA circuit corresponding to pixel units PX in the fourth row and the fifth row are located in the right border frame region. The sixth GOA circuit to the eighth GOA circuit corresponding to pixel units PX in the sixth row to the eighth row are located in the upper border frame region. Some pixel units PX in the ninth row and the tenth row are located in an R corner region 4, and correspondingly, the ninth GOA circuit and the tenth GOA circuit are in the upper border frame region.

Compared with the GOA circuits shown in FIG. 3, the GOA circuits shown in FIG. 6 sequentially move upward. When the left border frame region and the right border frame region do not accommodate some GOA circuits, the some GOA circuits are disposed in the upper border frame region.

In a possible implementation, a GOA circuit connected to a first pixel unit is disposed in a peripheral region corresponding to a third edge, and a GOA circuit connected to a second pixel unit is disposed in a peripheral region that are corresponding to a first edge and a second edge. The first pixel unit is a pixel unit from which a distance to the third edge in a column direction is less than or equal to a first threshold value, and the second pixel unit is a pixel unit from which a distance to the third edge in the column direction is less than or equal to the first threshold value.

For example, in a display panel in FIG. 6, the first threshold value is a distance from the pixel units in the sixth row to the upper border frame region in the column direction. GOA circuits corresponding to pixel units in the sixth row to the tenth row are disposed in the upper border frame region, and GOA circuits corresponding to remaining pixel units are disposed in the left border frame region and the right border frame region. It may be understood that a value of the first threshold value is related to a specific dimension of the display panel. This is not limited herein.

In this way, all GOA circuits are disposed in the upper border frame region, the left border frame region, and the right border frame region, to enable the GOA circuits not to occupy space in the R corner region. This narrows a border frame at an R corner, beautifies visual effect, and avoids wrinkles.

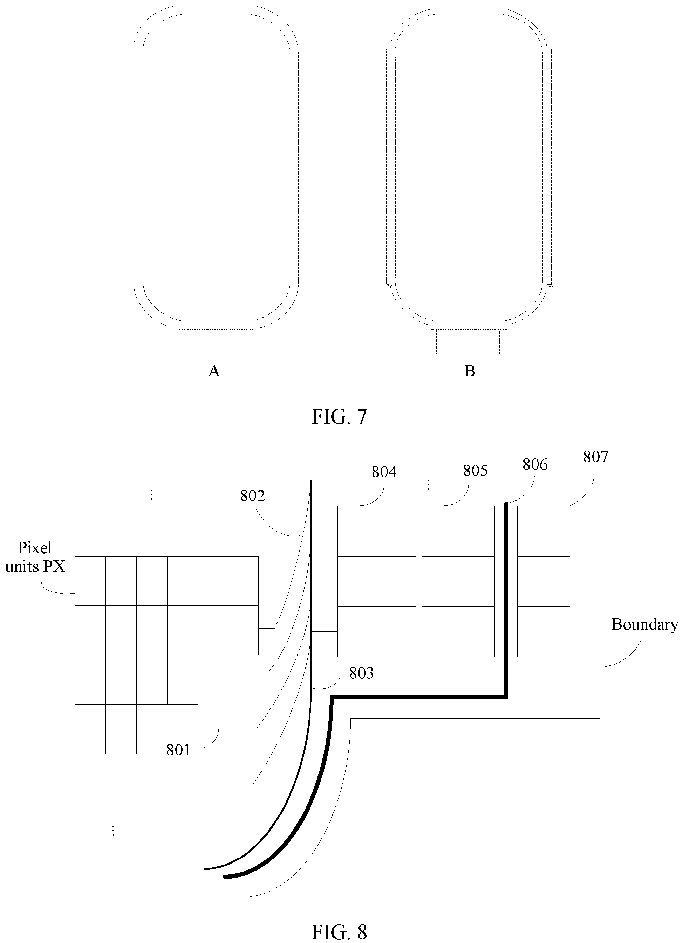

In this embodiment of this application, after the arrangement of the GOA circuits is changed, a border frame in the R corner region is narrowed. FIG. 7 is a comparison diagram according to an embodiment of this application. A in FIG. 7 is a plan view of a display panel corresponding to FIG. 3. B in FIG. 7 is a plan view of a display panel corresponding to FIG. 6. When an arrangement of a GOA circuit is changed, a border frame in an R corner region is narrowed, and a plan view of the display panel changes from the plan view shown in A in FIG. 7 to the plan view shown in B in FIG. 7.

Based on the foregoing embodiment, a VSS signal providing region of the R corner region may be removed, to further narrow the border frame in the R corner region. For example, in the display panel shown in FIG. 4, the VSS trace 404 in the R corner region may be removed.

It should be noted that a VSS signal in the display panel is transmitted to a pixel unit PX by bonding a cathode of the entire plane, and the VSS signal providing region in the R corner region provides the VSS signal to the pixel unit PX. Therefore, after the VSS signal providing region in the R corner region is removed, display effect of the display panel is not affected.

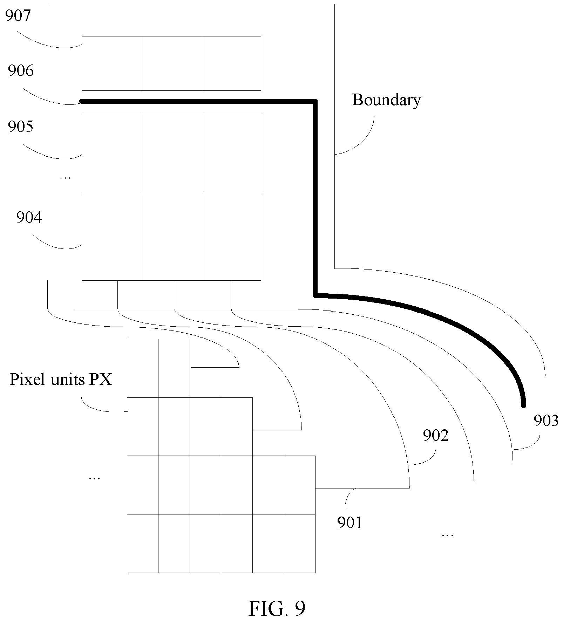

FIG. 8 and FIG. 9 are schematic plane views of parts in different regions of a display panel according to embodiments of this application. The following describes a peripheral region PA of the display panel with reference to FIG. 8 to FIG. 9.

FIG. 8 is a schematic plane view of a part of the display panel according to an embodiment of this application. As shown in FIG. 8, GOA circuits 804 are disposed in a right border frame region and do not occupy space in an R corner region. Pixel units PX corresponding to the R corner region and corresponding GOA circuits 804 are connected through GOA signal lines 802 and GOA output lines 801. The GOA signal line 802 extends to the right border frame region along the corner, to be connected to the GOA circuit 802.

The right border frame region in this embodiment of this application includes: the GOA signal line 802, the signal line 803 required for working of a pixel unit, the GOA circuits 804, a VSS signal providing region 805, a protection and detection region 806, and a Dam region 807. The R corner region includes: the GOA signal line 802, the signal line 803 required for working of a pixel unit, the protection and detection region 806, and the Dam region 807. The R corner region does not include the GOA circuit 802, the VSS signal providing region 803, and a VSS trace. A border frame in the R corner region is further narrowed.

FIG. 9 is an enlarged schematic diagram of a part corresponding to FIG. 6. As shown in FIG. 9, GOA circuits 904 are disposed in an upper border frame region and do not occupy space in an R corner region. Pixel units PX corresponding to the R corner region and corresponding GOA circuits 904 are connected through GOA signal lines 902 and GOA output lines 901. The GOA signal line 902 extends to a right border frame region along the corner, to be connected to the GOA circuit 902.

The right border frame region in this embodiment of this application includes: the GOA signal line 902, a signal line 903 required for working of a pixel unit, the GOA circuits 904, a VSS signal providing region 905, a protection and detection region 906, and a Dam region 907. The R comer region includes: the GOA signal line 902, the signal line 903 required for working of a pixel unit, the protection and detection region 906, and the Dam region 907. The R corner region does not include the GOA circuit 902, the VSS signal providing region 903, and a VSS trace. A border frame in the R corner region is further narrowed.

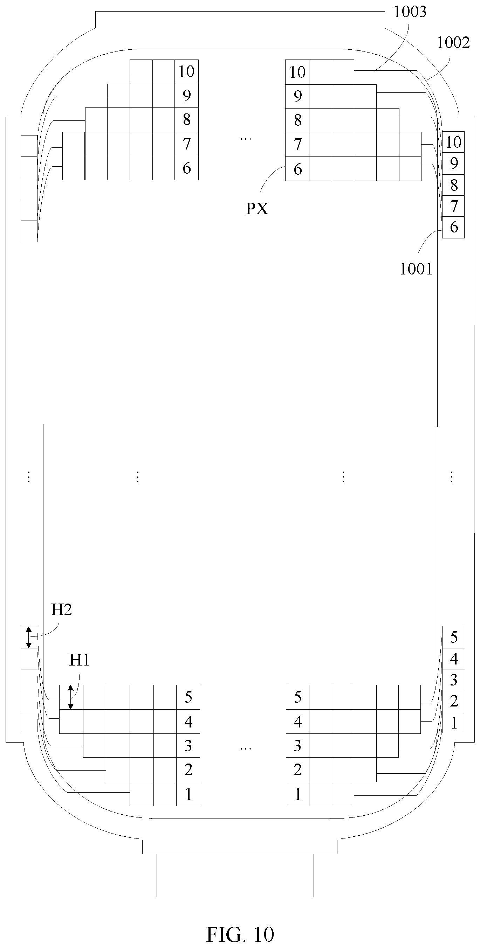

FIG. 10 is a schematic plane view of another arrangement of GOA circuits according to an embodiment of this application. As shown in FIG. 10, GOA circuits 1001 are separately disposed in a left border frame region and a right border frame region, and a longitudinal dimension H1 of the GOA circuit 1001 is smaller than a longitudinal dimension H2 of a corresponding pixel unit PX. The GOA circuits 1001 are connected to pixel units PX through GOA signal lines 1002 and GOA output lines 1003. FIG. 10 shows an example of ten rows of pixel units PX and corresponding GOA circuits. As shown in FIG. 10, pixel units PX in a first row to a tenth row are sequentially disposed from bottom to up in a display region DA, and a first GOA circuit to a tenth GOA circuit are sequentially disposed from bottom to up in a corresponding peripheral region PA.

It should be noted that, in this embodiment of this application, the longitudinal dimension H1 of the GOA circuit is smaller than a longitudinal dimension D2 of a pixel unit corresponding to the GOA circuit. In this way, more GOA circuits may be accommodated in the left border frame region and the right border frame region.

Specifically, some pixel units PX in the first row to the third row are located in an R corner region 2, and correspondingly, the first GOA circuit to the third GOA circuit are located in the right border frame region. The fourth GOA circuit to the tenth GOA circuit corresponding to pixel units PX in the fourth row to the tenth row are sequentially arranged.

Compared with the GOA circuit shown in FIG. 3, the longitudinal dimension H1 of the GOA circuit shown in FIG. 10 is smaller than the longitudinal dimension H2 of a pixel unit corresponding to the GOA circuit, so that GOA circuits corresponding to all pixel units in the display region may be accommodated in the left border frame region and the right border frame region. In this way, the GOA circuit does not occupy the space in the R corner, to narrow a border frame at the R corner and avoid the wrinkles.

Based on the foregoing embodiments, a distance between a PCD detection lead of the peripheral region and the corner is less than a distance between a Dam region and the corner. In this way, the PCD detection lead does not pass through the Dam region, to improve effect of isolating water and oxygen in the Dam region, and avoid effect loss of an organic material in the display region.

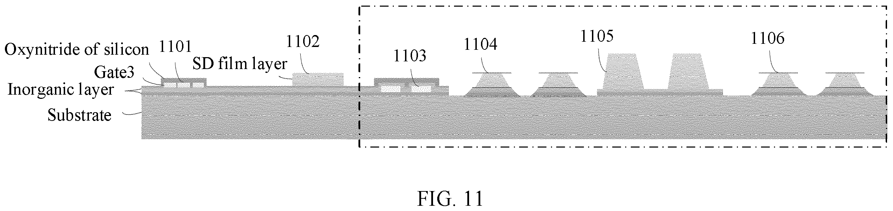

The following describes a structure of the R corner region in embodiments of this application with reference to FIG. 11 to FIG. 12.

FIG. 11 is a schematic diagram of a cross section of a border frame in an R corner region according to an embodiment of this application. The cross section includes: a GOA signal line 1101, a signal line 1102 required for working of a pixel unit, a PCD detection lead 1103, an inner isolation column 1104, a Dam region 1105, and an outer isolation column 1106.

In this embodiment of this application, a display panel has a plurality of film layers. Film layers in the R corner region in FIG. 11 are separately, from the bottom up, a substrate (PI), such as a flexible polyimide, two inorganic layers (an oxide of silicon and a nitride of silicon), Gate3, an oxynitride of silicon, and an SD film layer.

The GOA signal line 1101 is used to connect a plurality of pixel units PX, connected to the GOA signal line 1101, and then connected to a GOA circuit. The GOA signal line 1101 is located in the Gate3 film layer (a metal layer, for example, molybdenum Mo metal).

It should be noted that the GOA signal line may be located in a film layer that can conduct electricity, for example, a Gate1 film layer (a metal layer, for example, molybdenum Mo metal), a Gate2 film layer (metal layer, for example, molybdenum Mo metal), the Gate3 film layer (metal layer, for example, molybdenum Mo metal), an ITO film layer, the SD film layer (metal layer, titanium Ti/aluminum Al/titanium Ti), or the like. This is not limited herein.

The signal line 1102 required for working of a pixel unit includes a direct current signal line (vinit line). The signal line 1102 required for working of a pixel unit is located in the film layer that can conduct electricity, such as the SD (metal layer, Ti/Al/Ti titanium/aluminum/titanium).

The PCD detection lead 1103, the inner isolation column 1104, the Dam region 1105, and the outer isolation column 1106 are included in a packaging region of the display panel. There may be one or two Dam regions 1105. This is not limited in this embodiment of this application. The packaging region of the display panel may be rigid or flexible. This is not limited in this embodiment of this application.

It can be seen from the cross-sectional view of the border frame in the R corner region shown in FIG. 11 that, there is no GOA circuit and VSS trace at the border frame in the R corner region. The border frame in the R corner region is narrowed.

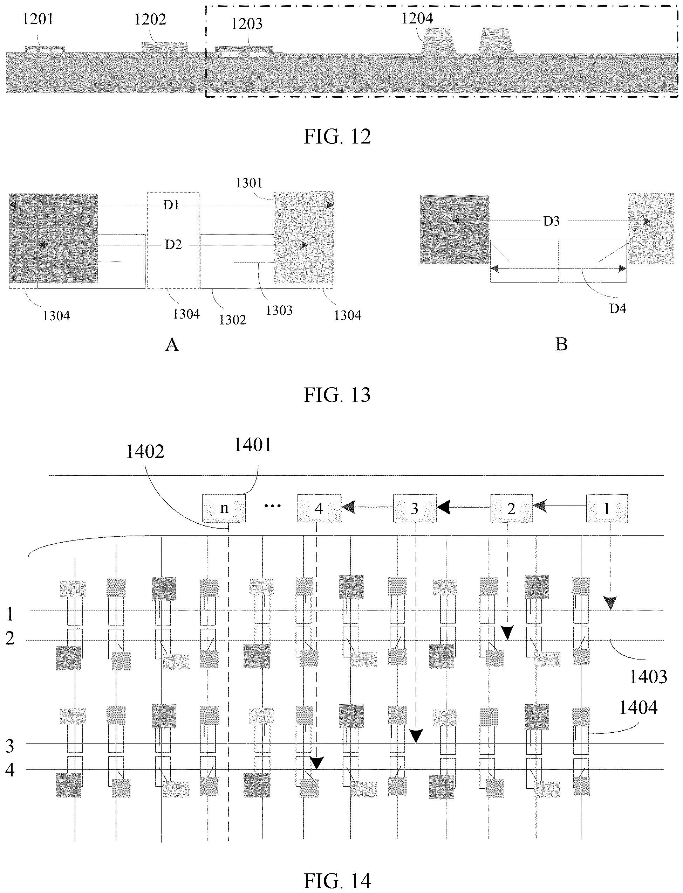

FIG. 12 is a schematic diagram of a cross section of another R corner region according to an embodiment of this application. The cross section includes: a GOA signal line 1201, a signal line 1202 required for working of a pixel unit, a PCD detection lead 1203, and a Dam region 1204.

For positions of the GOA signal line 1201, the signal line 1202 required for working of a pixel unit. Refer to the descriptions of corresponding components in FIG. 11.

In this embodiment of this application, a packaging region of a display panel includes the PCD detection lead 1203 and the Dam region 1204, and does not include an inner isolation column and an outer isolation column. A structure of the packaging region is not limited in this embodiment of this application.

Based on the foregoing embodiments, to narrow a border frame at an R corner, GOA signal lines and/or data connection lines in the display panel may pass through a gap between pixel units. The following describes an arrangement of the GOA signal lines and the data connection lines with reference to FIG. 13 to FIG. 15.

FIG. 13 is a schematic diagram of a structure of a pixel unit according to an embodiment of this application. As shown in A in FIG. 13, the pixel unit includes a light-emitting device 1301, a bottom drive circuit 1302, and an anode lead 1303.

The light-emitting device 1301 is connected to the bottom drive circuit 1302 by using the anode lead 1303.

The light-emitting device 1301 is configured to emit light. The light-emitting device 1301 may emit one or more of red light, green light, and blue light. This is not limited in this embodiment of this application. For example, each light-emitting device 1301 may alternatively emit light of other colors such as cyan, magenta, and yellow. Light emitted by a plurality of light-emitting devices 1301 constitutes a display image. The light-emitting device 1301 may be an organic light-emitting diode. Dimensions and shapes of the light-emitting devices 1301 may be the same, or may not be different. This is not limited in this embodiment of this application.

The bottom drive circuit 1302 is configured to drive the light-emitting device 1301. The bottom drive circuit 1302 may include a plurality of transistors, capacitors, and the like.

For example, the bottom drive circuit 1302 may include a first transistor T1, a second transistor T2, and a capacitor Cst. The first transistor T1 and the second transistor T2 may be thin film transistors.

The second transistor T2 is a switching transistor, and may be connected to a scanning line and a data line. The second transistor T2 is configured to transmit, to the first transistor T1 based on a switching voltage input to the scanning line, a data signal input from the data line.

The capacitor Cst may be connected to the second transistor T2 and a supply voltage line. The capacitor Cst is configured to store a voltage corresponding to a difference between a voltage corresponding to the data signal received from the second transistor T2 and a first supply voltage ELVDD supplied to the supply voltage line. The supply voltage line may be spaced parallel to the scanning line or the data line.

The first transistor T1 is a drive transistor, and may be connected to the supply voltage line and the capacitor Cst. The first transistor T1 is configured to control, in response to a voltage value stored in the capacitor Cst, a drive current Ioled flowing through the light-emitting device 1301, to control light-emitting intensity of the light-emitting device 1301, and the like. The bottom drive circuit 1302 may alternatively be a 7T1C circuit or the like. A quantity of transistors and a quantity of capacitors may be variable based on a design of the bottom drive circuit. This is not limited in this embodiment of this application.

In this embodiment of this application, a dimension of a region enclosed by the bottom drive circuits is smaller than a dimension of a region enclosed by the pixel unit. This enables a gap to exist between the bottom drive circuits, and subsequently the GOA signal line and the data connection line pass through the gap. For example, a dimension of the light-emitting device in a row direction is larger than a dimension of the bottom drive circuit corresponding to the adjacent light-emitting devices in the row direction.

In the pixel unit as shown in A in FIG. 13, a dimension D2 of a region enclosed by the bottom drive circuits in a row direction is smaller than a dimension D1 of a region enclosed by the pixel units in the row direction. This enables a gap 1304 to exist between the bottom drive circuits.

When D 1 is larger than D2, it may be understood that a width of the bottom drive circuit 1302 is smaller than a width of the light-emitting device 1301 controlled by the bottom drive circuit. Alternatively, it may be understood that occupation space of the bottom drive circuit 1302 of the pixel unit is smaller than occupation space of the light-emitting device 1301 controlled by the bottom drive circuit, or the plurality of light-emitting devices 1301 are divergent relative to corresponding bottom drive circuits 1302. In this way, the gap 1304 exists between adjacent bottom drive circuits 1302. This improves transmittance of a backplane. Alternatively, the gap is used to arrange the GOA signal line and the data connection line.

In a possible implementation, to increase a width of the gap, and facilitate arrangement of the GOA signal line and the data connection line, an interval between geometric centers of adjacent light-emitting devices in the row direction is larger than a dimension between corresponding bottom drive circuits in the row direction. For the pixel unit shown in B in FIG. 13, D3 is a dimension between geometric centers of adjacent light-emitting devices in the row direction, and D4 is a dimension between the adjacent bottom drive circuits in the row direction. D3 is larger than D4. In a possible implementation, one pixel unit includes a plurality of light-emitting devices. The bottom drive circuits of the plurality of light-emitting devices may be arranged or integrated together, to enable a ratio of an area of the plurality of bottom drive circuits to an area of the plurality of light-emitting devices in the pixel unit to be less than 1.

The following describes an arrangement of the GOA signal lines. FIG. 14 is a schematic diagram of a structure of a specific display circuit according to an embodiment of this application. As shown in FIG. 14, the display circuit includes GOA circuits 1401, GOA signal lines 1402, GOA output lines 1403, and pixel units 1404. FIG. 14 shows an example of two rows and 12 columns of pixel units 1404 and a plurality of GOA circuits 1401. The GOA signal line 1402 is connected to the GOA circuit 1401 and the GOA output line 1403. The GOA output line 1403 is used to connect bottom drive circuits corresponding to a row of light-emitting devices.

The GOA circuit 1401 is located in an upper border frame region. The GOA signal line 1402 extends in a column direction and passes through a gap between the pixel units 1404, to connect to a corresponding GOA output line 1403. For example, a first GOA circuit 1201 is connected to a GOA output line 1403 corresponding to light-emitting devices in a first row through the GOA signal line 1402 and the GOA output line 1403.

In the display circuit shown in FIG. 14, the GOA signal line passes the pixel unit, so as not to extend from an R corner. This saves space at the R corner. In the display circuit shown in FIG. 14, the R corner of the display panel is narrowed, so that the display panel is more beautiful.

In a possible implementation, the bottom drive circuits corresponding to the light-emitting devices in the pixel units may be arranged together, so that occupation space is further reduced. A space distance between adjacent pixel units is large, to accommodate arrangement of more GOA signal lines.

It may be understood that the GOA signal line in FIG. 14 linearly extends, and the GOA signal line may alternatively extend in a curved shape and/or is connected at a rounded angle. The GOA signal line may be arranged between pixel units in a Z shape, a Q shape, or a zigzag shape. A specific arrangement shape of the GOA signal line is not limited in this embodiment of this application.

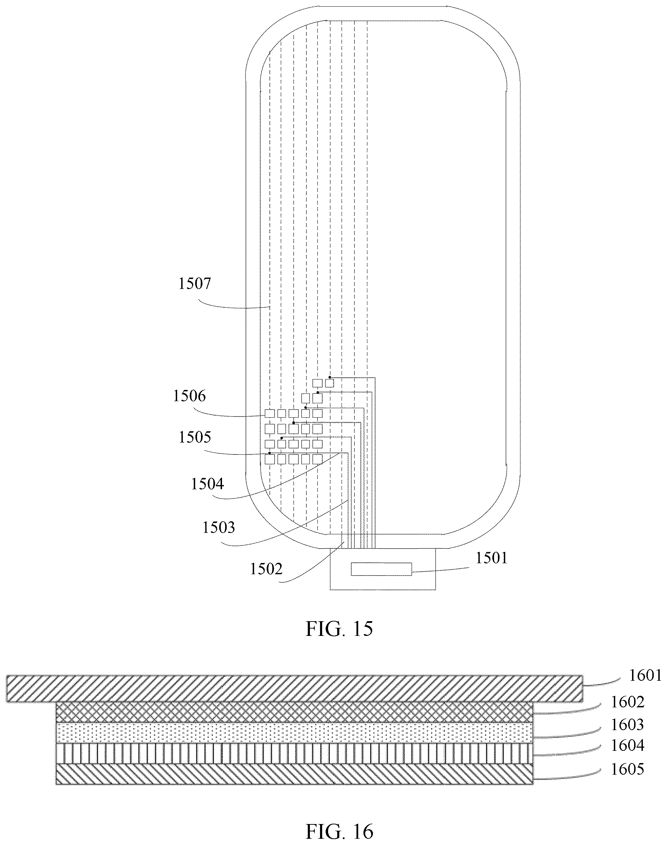

The following describes an arrangement of the data connection lines. FIG. 15 is a schematic diagram of a structure of a display panel according to an embodiment of this application. A display circuit includes: a signal providing region 1501, a signal lead region 1502, data leads I 1503, data leads II 1504, signal adapters 1505, pixel units 1506, and data lines 1507.

The signal providing region 1501 is used to output a data signal. The signal providing region 1501 is connected to a data driver, to output the data signal.

The signal lead region 1502 includes a plurality of signal leads. Two ends of each signal lead respectively are connected to the signal providing region 1501 and the data line 1507, or respectively connected to the signal providing region 1501 and the data lead I 1503. The signal lead region 1502 is used to transmit the data signal to the data line 1507 or the data lead I 1503. It should be noted that the signal lead may also be referred to as a signal line.

The data lead I 1503 and the data lead II 1504 are respectively data leads arranged in two directions, and are used to connect the signal providing region 1501 and the data line 1507. The data lead I 1503 are arranged in a column direction of the pixel unit 1506. The data lead II 1504 are arranged in a row direction of the pixel unit 1506. The data lead I 1503 may also be referred to as a second connection line part, and the data lead II 1504 may also be referred to as a first connection line part. The data lead I 1503 and the data lead I 1504 may be collectively referred to as a data connection line.

The data lead I 1503 and the data lead II 1504 may be located in a film layer that can conduct electricity, for example, a Gate1 film layer (metal layer, such as molybdenum (Mo) metal or the like), a Gate2 film layer (metal layer, such as molybdenum (Mo) metal or the like), a Gate3 film layer (metal layer, such as molybdenum (Mo) metal or the like), an ITO film layer, or an SD film layer (metal layer, Metal layer, Ti/Al/Ti titanium/aluminum/titanium), or the like. This is not limited herein.

The signal adapter 1505 is configured to connect the data lead II 1504 and the data line 1507.

The pixel unit 1506 is used to emit light based on a data signal transmitted by the data line 1507.

The data line 1507 is used to transmit the data signal, and the data signal transmitted by the data line 1507 can control the pixel unit 1506 to emit light or not to emit light, control intensity of an emitted light, and the like.

It may be understood that a data signal outputted by the signal providing region 1501 is transmitted to the data line 1507 through the signal lead region 1502, to control display of a column of pixel units 1506 corresponding to the data line 1507. The data signal output from the signal providing region 1501 is transmitted to the data line 1507 through the signal lead region 1502, the data lead 1 1503, the data lead II 1504, and the signal line adapter 1505, to control display of the column of pixel units 1506 corresponding to the data line 1507.

In the display circuit shown in FIG. 15, the data lead passes the pixel units, so as not to extend from the R corner. This saves space at the R corner and a lower border frame. In the display circuit shown in FIG. 15, the lower border frame of the display panel is narrowed, so that the display is more beautiful.

In a possible implementation, the bottom drive circuits corresponding to the light-emitting devices in the pixel units may be arranged together, so that occupation space is further reduced. A space distance between adjacent pixel units is large, to accommodate arrangement of more data connection lines.

It may be understood that the data connection line in FIG. 15 linearly extends and is connected at a right angle, and the data connection line may alternatively extend in a curved shape and/or is connected at a rounded angle. The data connection line may be arranged between pixel units in a Z shape, a Q shape, or a zigzag shape. A specific arrangement shape of the data connection line is not limited in this embodiment of this application.

An embodiment of this application further provides a display. The display includes the foregoing display panel, and the display panel is configured to display an image. For example,

FIG. 16 is a schematic diagram of a structure of a display according to an embodiment of this application. As shown in FIG. 16, the display includes, but is not limited to, a protection cover plate 1601, a polarizer 1602, a display panel 1603, a heat dissipation layer 1604, and a protection layer 1605.

The polarizer 1602 is fixed to the protection cover plate 1601. The protection cover plate 1601 may be a transparent glass cover plate or an organic material cover plate such as polyimide, to reduce impact on display effect of the display while providing protection. The polarizer 1602 may be a circular polarizer, and is configured to avoid anode reflection of light. The heat dissipation layer 1604 may be a heat dissipation copper foil, and the protection layer 1605 may be a protection foam. The layer structures of the display may be bonded by using an optical transparent adhesive or a non-transparent pressure-sensitive adhesive. In addition, because ingredients such as water vapor and oxygen in the air have great impact on service life of a light-emitting device of the display panel 1603, water-and-oxygen encapsulation needs to be strictly performed on the light-emitting device of the display panel, to sufficiently separate functional layers of the light-emitting device from the ingredients such as water vapor and oxygen in the air.

In this embodiment of this application, the display may be a flexible display or a rigid display. For example, the display may be an OLED display, a QLED flexible display, a curled screen, a foldable screen, or the like.

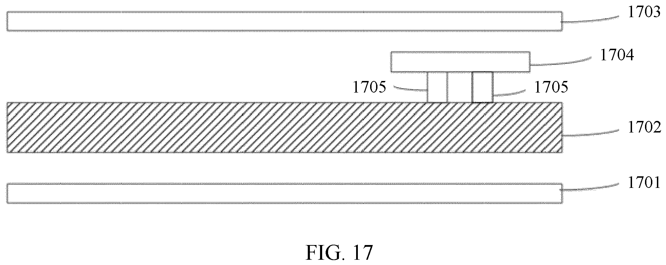

An embodiment of this application further provides a display device. The display device includes the foregoing display, and the display is configured to display an image. For example, as shown in FIG. 17, the display device includes, but is not limited to, a display 1701, a middle frame 1702, a rear housing 1703, and a printed circuit board (printed circuit board, PCB) 1704. The middle frame 1702 may be configured to bear the printed circuit board and the display 1701. The display 1701 and the printed circuit board are located on two sides of the middle frame 1702, and the rear housing 1703 is located on one side of the printed circuit board away from the middle frame 1702. In addition, the display device may further include components 1705 disposed on the PCB 1704, where the component 1705 may be, but is not limited to be, disposed on one side of the PCB 1704 toward the middle frame 1702.

In this embodiment of this application, the display device may be a terminal device having a display. For example, the terminal device includes: a mobile phone (mobile phone), a tablet computer, a notebook computer, a palmtop computer, a mobile internet device (mobile internet device, MID), a wearable device, a virtual reality (virtual reality, VR) device, an augmented reality (augmented reality, AR) device, a wireless terminal in industrial control (industrial control), a wireless terminal in self driving (self driving), a wireless terminal in remote medical surgery (remote medical surgery), a wireless terminal in smart grid (smart grid), a wireless terminal in transportation safety (transportation safety), a wireless terminal in smart city (smart city), a wireless terminal in smart home (smart home), a cellular phone, a cordless phone, a session initiation protocol (session initiation protocol, SIP) phone, a wireless local loop (wireless local loop, WLL) station, a personal digital assistant (personal digital assistant, PDA), a handheld device having a wireless communication function, a computing device or another processing device connected to a wireless modem, a vehicle-mounted device, a wearable device, a terminal device in a 5G network, a terminal device in a future evolved public land mobile network (public land mobile network, PLMN), or the like. This is not limited in this embodiment of this application.

In addition, in this embodiment of this application, the terminal device may also be a terminal device in an Internet of Things (Internet of Things, IoT) system. IoT is an important part in future development of information technologies, and is mainly technically characterized in that things are connected to networks through communication technologies, to achieve intelligent networks of human-machine interconnection and interconnection between things.

The terminal device in this embodiment of this application may alternatively be referred to as user equipment (user equipment, UE), a mobile station (mobile station, MS), a mobile terminal (mobile terminal, MT), an access terminal, a user unit, a user station, a mobile site, a mobile station, a remote station, a remote terminal, a mobile device, a user terminal, a terminal, a wireless communication device, a user agent, or a user apparatus.

In embodiments of this application, the terminal device or each network device includes a hardware layer, an operating system layer that runs at the hardware layer, and an application layer that runs at the operating system layer. The hardware layer includes hardware such as a central processing unit (central processing unit, CPU), a memory management unit (memory management unit, MMU), and an internal memory (also referred to as a main memory). The operating system may be any one or more computer operating systems for implementing service processing through a process (process), for example, a Linux operating system, a Unix operating system, an Android operating system, an iOS operating system, or a Windows operating system. The application layer includes applications such as a browser, an address book, word processing software, and instant messaging software.

The foregoing descriptions are merely specific implementations of this application, but the protection scope of embodiments of this application is not limited thereto. Any variation or replacement within the technical scope disclosed in embodiments of this application shall fall within the protection scope of embodiments of this application. Therefore, the protection scope of embodiments of this application shall be subject to the protection scope of the claims.

## Claims

1. A display panel, comprising: a display region and a peripheral region that at least partially surrounds the display region, wherein the display region comprises a first edge, a second edge, a third edge, and a fourth edge, the first edge is disposed opposite to the second edge, the third edge is disposed opposite to the fourth edge, and a corner between the first edge and the fourth edge is curved;
the display region comprises a plurality of pixel units;
peripheral regions corresponding to the first edge, the second edge, and the third edge each comprise a gate driver on array GOA circuit and a GOA signal line; the GOA circuit is configured to drive the pixel unit, and the GOA signal line is used to connect the GOA circuit and the pixel unit; and
the peripheral regions corresponding to the first edge, the second edge and the third edge comprise all GOA circuits.

2. The display panel according to claim 1, wherein a peripheral region corresponding to the corner comprises a panel crack detection PCD lead and a water-and-oxygen dam (Dam) region, and a distance between the PCD lead and the corner is less than a distance between the Dam region and the corner, to enable the PCD lead not to pass through the Dam region.

3. The display panel according to claim 1 or 2, wherein the peripheral region corresponding to the corner further comprises an isolation column, and the isolation column is disposed on both sides of the Dam region.

4. The display panel according to claim 1 or 2, wherein a width of the peripheral region at the corner is smaller than a width of the peripheral region at the first edge.

5. A display panel, comprising: a display region and a peripheral region that at least partially surrounds the display region, wherein the display region comprises a first edge, a second edge, a third edge, and a fourth edge, the first edge is disposed opposite to the second edge, the third edge is disposed opposite to the fourth edge, and a corner between the first edge and the fourth edge is curved;
the display region comprises a plurality of pixel units;
peripheral regions corresponding to the first edge and the second edge each comprise a gate driver on array GOA circuit and a GOA signal line; the GOA circuit is configured to drive the pixel unit, and the GOA signal line is used to connect the GOA circuit and the pixel unit; and
a longitudinal dimension of the GOA circuit is smaller than a longitudinal dimension of a pixel unit corresponding to the GOA circuit, to enable peripheral regions corresponding to the first edge and the second edge to comprise all GOA circuits.

6. The display panel according to claim 5, wherein a peripheral region corresponding to the corner comprises a PCD lead and a Dam region, a distance between the PCD lead and the corner is less than a distance between the Dam region and the corner, to enable the PCD lead not to pass through the Dam region.

7. The display panel according to claim 5 or 6, wherein the peripheral region corresponding to the corner further comprises an isolation column, and the isolation column is disposed on both sides of the Dam region.

8. The display panel according to claim 5 or 6, wherein a width of the peripheral region at the corner is smaller than a width of the peripheral region at the first edge.

9. The display panel according to claim 1 or 5, wherein the peripheral region comprises a signal providing region, the signal providing region is adjacent to the fourth edge, and a length of the signal providing region is smaller than or equal to a length of the fourth edge;
the display region further comprises K data connection lines disposed between the pixel units, and K is a natural number;
the pixel units comprise M columns * N rows of light-emitting devices, M columns * N rows of bottom drive circuits, and M * N anode leads, the anode leads are used to connect the light-emitting devices to the bottom drive circuits, the bottom drive circuits are disposed at lower layers of the light-emitting devices, and both M and N are natural numbers,
wherein an interval between adjacent light-emitting devices in the pixel unit is larger than a dimension of the bottom drive circuits corresponding to the adjacent light-emitting devices in the pixel units, to enable a gap to exist between the pixel units; and
the K data connection lines are used to pass through gaps between the plurality of pixel units in the display region, and to connect pixel units in Q columns in the plurality of pixel units to the signal providing region, and the pixel units in Q columns comprise pixel units corresponding to the corner, and Q is a natural number less than or equal to K.

10. A display, comprising the display panel according to any one of claims 1 to 9, wherein the display panel is configured to display an image.

11. A display device, comprising the display according to claim 10, wherein the display is configured to display an image.
